Europäisches Patentamt

European Patent Office

Office européen des brevets

(11) Numéro de publication: **0 323 378**
**A2**

(12) # DEMANDE DE BREVET EUROPEEN

(21) Numéro de dépôt: 88440112.6

(22) Date de dépôt: 23.12.88

(51) Int. Cl.4: **G 02 B 26/08**
G 01 R 9/02, H 01 F 7/06

(30) Priorité: 24.12.87 FR 8718469

(43) Date de publication de la demande:
05.07.89 Bulletin 89/27

(84) Etats contractants désignés:
AT BE CH DE ES GB GR IT LI LU NL SE

(71) Demandeur: TECHNEME SàRL
15 bis, rue Fontaine de la Ville
F-06300 Nice (FR)

(72) Inventeur: Castelo, Véronique
15 bis rue Fontaine de la Ville
F-06300 Nice (FR)

Delache, Alain
15 bis, rue fontaine de la ville
06300 - NICE (FR)

(74) Mandataire: Arbousse-Bastide, Jean-Claude Philippe
CABINET ARBOUSSE BASTIDE 20, rue de Copenhague
F-67000 Strasbourg (FR)

(54) Dispositif à miroir(S) oscillant(S) pour la déviation de rayons électromagnétiques.

(57) Dispositif à miroir(s) oscillant(s) pour la déviation de rayons électromagnétiques comportant au moins un miroir solidaire d'un bobinage alimenté en courant électrique et placé dans un champ magnétique.

Le champ magnétique est un champ de grande intensité, créé par un ensemble de trois aimants (1a, 1b, 1c) réalisés en un matériau magnétique de produit d'énergie supérieur à 100 kj/m³, disposés parallèlement les uns aux autres et le miroir (2) est solidarisé au bobinage (3), l'ensemble miroir-bobinage étant fixé sur un support élastique (4) rendu solidaire de l'aimant médian (1b).

Ce dispositif permet de faire vibrer un miroir à des fréquences allant jusqu'à plusieurs kilo-hertz, ouvrant la porte à de nombreuses applications telles que, en émission, la déviation de rayons lasers pour la réalisation de dessins, de graphiques, de découpes ou de gravures et en réception, le balayage d'un plan ou d'un volume pour caméras à infra-rouges.

Fig. 1

EP 0 323 378 A2

Bundesdruckerei Berlin

## Description

### DISPOSITIF A MIROIR(S) OSCILLANT(S) POUR LA DEVIATION DE RAYONS ELECTROMAGNETIQUES.

La présente invention a pour objet un dispositif à miroir oscillant pour la déviation de rayons électromagnétiques.

On sait que des dispositifs apparentés aux galvanomètres sont mis en oeuvre depuis longtemps dans différents secteurs de la technique : ainsi les premiers oscilloscopes fonctionnaient avec des systèmes à miroir oscillant.

De tels dispositifs sont généralement constitués de miroirs tournants montés sur axe et pilotés soit par des moteurs à grande vitesse, soit par des électro-aimants.

La nécessité de pousser les performances de ces systèmes a conduit les demandeurs à orienter leurs recherches vers la mise au point d'un dispositif susceptible de faire osciller un miroir à grande vitesse de façon contrôlable et modulable.

Le dispositif selon l'invention répond à cette exigence car il permet de faire vibrer un miroir de zéro à plusieurs kilo-Hertz, ouvrant ainsi la porte à ne nombreuses applications qui seront exposées plus loin.

Le dispositif selon l'invention présente la caractéristique essentielle de comporter un miroir solidaire d'un bobinage situé dans un champ magnétique intense et susceptible d'osciller à grande fréquence sur un support réalisé en un matériau élastique sur lequel l'ensemble miroir-bobinage est fixé par collage.

La mise en oeuvre d'un support élastique et d'un champ magnétique intense dans le dispositif selon l'invention présente un certain nombre d'avantages remarquables par rapport aux dispositifs existants, tant en ce qui concerne la vitesse d'oscillation déjà évoquée qu'en ce qui concerne la fiabilité et la compacité du système, ainsi que la puissance électrique qu'il requiert pour son fonctionnement.

En effet, le support élastique, tout en assurant l'amortissement des oscillations de l'ensemble miroir-bobinage, permet d'éviter le recours à des pièces mécaniques en frottement ou en rotation, telles que des roulements à bille qui se détériorent progressivement dans le temps; il en résulte une fiabilité exemplaire du dispositif selon l'invention.

Par ailleurs, la commande du dispositif selon l'invention ne nécessite pas la mise en oeuvre d'un ensemble électronique de grande puissance, comme c'est le cas pour les dispositifs existants, puisque quelques watts peuvent suffire pour le piloter.

Ce fait, joint à la simplicité du dispositif, permet au système selon l'invention de présenter l'avantage supplémentaire d'une compacité considérablement réduite allant jusqu'à la miniaturisation, le volume de l'ensemble pouvant être inférieur au dixième de celui des systèmes existants (de l'ordre de 12 mm x 10 mm x 15 mm).

Enfin, le dispositif selon l'invention offre également l'avantage d'une linéarité de fonctionnement de O Hertz à plusieurs kilo-Hertz, ce qui constitue une autre supériorité sur la plupart des systèmes existants, dont certains ne fonctionnent qu'à une seule fréquence.

Tous les avantages qui viennent d'être exposés résultent en des performances tout à fait exceptionnelles du dispositif selon l'invention, qui peut être miniaturisé à l'extrême, ces performances exceptionnelles tenant, ainsi qu'il a déjà été dit, à la mise en oeuvre conjointe d'aimants de grande puissance et d'un support du miroir aux propriétés élastiques.

Les aimants mis en oeuvre dans le dispositif selon l'invention sont en effet des aimants de produit d'énergie supérieur à 100 kj/m$^3$, aptes à créer des champs magnétiques de grande intensité.

Ces aimants de grande puissance sont réalisés dans un matériau magnétique du type Néodyne-Fer, dont le produit d'énergie peut dépasser 200 kj/m$^3$.

Les aimants mis en oeuvre dans le dispositif selon l'invention peuvent être constitués d'un ensemble de deux aimants dont l'un affecte approximativement la forme d'un "U" et l'autre la forme d'un parallélépipède, placé dans l'entrefer du premier.

Ils peuvent être également constitués de trois plaquettes frittées d'un matériau magnétique du type Néodyne-Fer disposées parallèlement sur un support, réalisé ou non dans le même matériau.

Ils peuvent être aussi constitués d'un seul bloc affectant grossièrement la forme d'un "E".

Dans l'un et l'autre cas, le support du miroir est fixé sur l'élément médian par collage au moyen d'une colle appropriée qui peut être du type cyanacrylate, l'ensemble miroir-bobinage venant coiffer ledit support.

Le support élastique mis en oeuvre peut être réalisé soit en un matériau purement élastique ou présentant un faible coefficient d'amortissement, soit en un matériau présentant un fort coefficient d'amortissement, selon la réponse attendue.

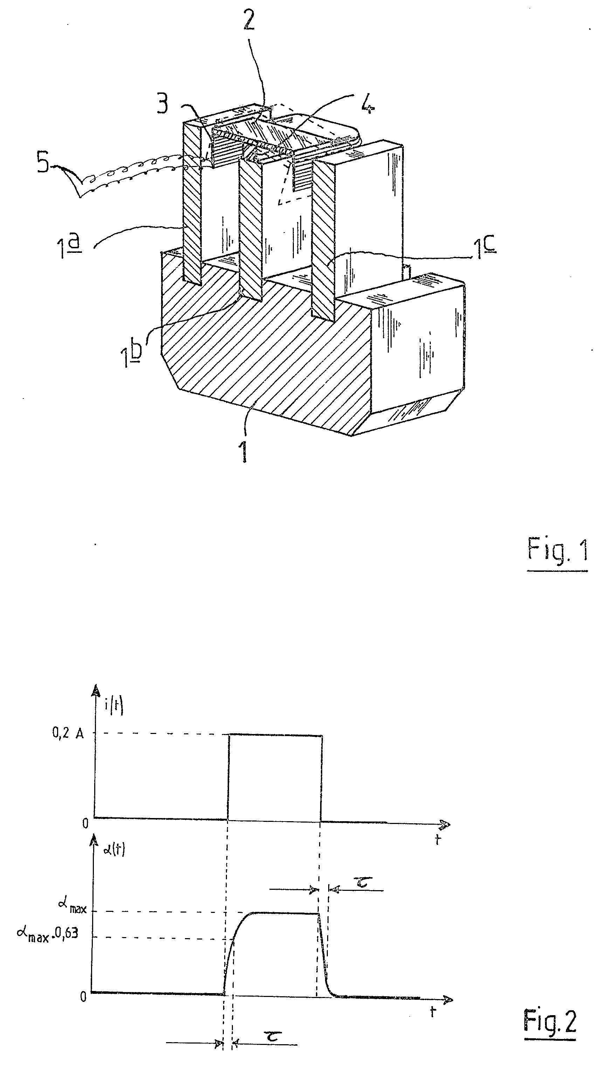

Dans le cas où le support du miroir est réalisé en un matériau élastique présentant un fort coefficient d'amortissement, le système peut présenter une courbe de réponse particulièrement satisfaisante, telle que celle représentée sur la figure 2 annexée, où i(t) désigne l'intensité du courant traversant la bobine, $\alpha$ (t) la réponse angulaire du miroir et $\tau$ le temps de montée du système à 63 %.

Le matériau mis en oeuvre dans ce cas est avantageusement un polyuréthane, tel celui commercialisé sous la dénomination "SORBOTHANE".

Dans le cas où le support du miroir est réalisé en un matériau purement élastique ou présentant un faible coefficient d'amortissement, le système ne peut être utilisé qu'à sa fréquence de résonance propre, à moins que sa commande électronique n'intègre un filtre destiné à compenser la résonance propre du système.

Le matériau mis en oeuvre dans ce cas peut être n'importe quel matériau élastique, tel qu'un latex naturel ou un latex d'élastomère de synthèse du type styrène-butadiène ou styrène-butadiène-styrène.

Ce support élastique, ainsi qu'il a déjà été dit, supporte l'ensemble miroir-bobinage, qui lui est fixé par collage au moyen d'une colle appropriée, telle qu'un cyanacrylate.

Le miroir mis en oeuvre dans le dispositif selon l'invention est avantageusement un miroir alliant légèreté, rigidité, tenue en température et performances optiques.

Le matériau utilisé comme support de la surface réfléchissante peut être un verre extrêmement fin, d'épaisseur inférieure à O,2 mm du bérylium d'épaisseur inférieure à O,4 mm ou encore une polysulfone.

L'argenture ou l'aluminure constituant la surface réfléchissante du miroir doit avantageusement présenter un spectre de réflexion le plus large possible pour pouvoir couvrir des applications allant de l'infra-rouge aux rayons X.

Le bobinage mis en oeuvre dans le dispositif selon l'invention est réalisé en un conducteur métallique pouvant être le cuivre ou un alliage complexe de conductivité elevée.

Le conducteur métallique mis en oeuvre peut affecter la forme d'un fil, auquel cas le bobinage est formé en spires superposées, sur une ou deux couches.

Ce fil peut être très fin, de l'ordre de quelques centièmes de millimètres de diamétre, si l'on veut un dispositif très miniaturisé. On peut ainsi mettre en oeuvre, à titre d'exemple, un fil de cuivre émaillé de 4/100 mm de diamètre, formé en 100 spires superposées en 2 couches.

Le bobinage peut également consister en une incrustation sur le matériau constituant le support de la surface réfléchissante du miroir, auquel cas le miroir occupe la partie centrale de ce support et est entouré de l'incrustation constituant le bobinage, lequel prend approximativement la forme d'une spirale.

Dans le cas où le bobinage est constitué d'un fil métallique formé en spires, il est de préférence réalisé sans support, de manière à contribuer à la légèreté du dispositif.

Dans ce cas, le miroir est fixé sur le bobinage par collage au moyen d'une colle appropriée, telle qu'un cyanacrylate, cette fixation se faisant de préférence sur deux côtés opposés du polygone formé par les spires.

L'ensemble miroir-bobinage est, ainsi qu'il a déjà été dit, fixé par collage sur le support élastique, lui-même fixé également par collage sur l'aimant médian de l'ensemble d'aimants mis en oeuvre.

Cette fixation de l'ensemble miroir-bobinage sur le support élastique peut se faire de différentes façons correspondant à différentes configurations dudit support élastique. La fixation peut ainsi se faire soit sur le miroir seul, soit à la fois sur le miroir et le bobinage.

Ainsi, dans un premier mode de réalisation du dispositif selon l'invention, le bobinage affecte grossièrement la forme d'un parallélépipède rectangle, le miroir est collé sur les deux grands côtés du rectangle qui constitue la face supérieure de ce parallélépipède, et l'ensemble miroir bobinage vient coiffer l'aimant médian de l'ensemble d'aimants mis en oeuvre.

Selon une variante de ce mode de réalisation du dispositif selon l'invention, le support élastique peut affecter la forme d'un parallélépipède rectangle, d'un tonneau ou d'une bobine, ou toute autre forme appropriée, et être fixé uniquement sur le miroir.

Selon une autre variante de ce mode de réalisation, le support élastique peut être constitué d'un bloc collé à la fois au miroir et au bobinage.

Selon une autre variante encore, le support élastique peut être constitué de deux éléments en "L" inversé dont chacun est fixé d'une part à l'aimant médian, et d'autre part à une face interne du parallélépipède configuré par le bobinage.

Enfin, selon une dernière variante, le support élastique peut être constitué de deux éléments situés de part et d'autre de l'aimant médian et supportant deux côtés opposés du parallélépipède configuré par le bobinage.

Dans un second mode de réalisation du dispositif selon l'invention, le bobinage est constitué d'incrustations métalliques ménagées, autour du miroir, sur la surface qui en supporte l'argenture ou l'aluminure.

Dans ce mode de réalisation, le miroir est fixé sur le support élastique, qui peut affecter la forme d'un parallélépipède rectangle, d'un tonneau ou d'une bobine, et qui est fixé sur l'aimant médian.

Dans tous les cas, le bobinage est alimenté par une source de courant ou de tension électrique comportant des moyens pour moduler l'intensité, la fréquence et la forme du courant admis dans le bobinage. Sous l'action du courant électrique et du champ magnétique, le miroir se met à osciller à une fréquence égale à celle du courant, l'amplitude des oscillations étant fonction tout à la fois de l'intensité du champ magnétique et de l'amplitude maximale du courant.

Ces paramètres étant convenablement choisis, les oscillations du miroir peuvent être avantageusement utilisées pour dévier des rayons électromagnétiques, le pilotage de l'ensemble étant réalisé par des moyens électroniques appropriés.

Un mode de réalisation particulièrement avantageux du dispositif selon l'invention, garantissant sa reproductibilité, consiste à adjoindre au bobinage solidaire du miroir un bobinage secondaire de moindres dimensions, solidarisé à l'une des deux faces du bobinage qui se trouvent dans les entrefers formés par les trois aimants parallèles, et positionné de telle manière qu'il ne puisse recueillir aucun courant induit par le bobinage principal, le seul courant y apparaissant étant celui induit par son déplacement à l'intérieur du champ magnétique créé par les aimants.

Un traitement convenable de ce courant par un mode d'asservissement approprié permet un réglage de la position de la vitesse et de l'accélération instantanées du miroir, satisfaisant aux exigences de linéarité du système.

Le mode d'asservissement mis en oeuvre pour le traitement du courant peut être soit un mode d'asservissement numérique, soit un mode d'asservissement analogique tel qu'un asservissement proportionnel, un asservissement dérivé, un asservissement intégral, un asservissement proportionnel dérivé, un asservissement proportionnel intégral, un asservissement intégral dérivé, ou un asservissement proportionnel intégral dérivé.

A titre d'exemple d'un tel mode d'asservissement on peut citer le mode d'asservissement proportionnel dérivé qui consiste en un amplificateur à gain variable suivi d'un soustracteur de tension, permettant de soustraire la tension correspondant au courant de la tension de commande du bobinage principal, ce qui équivaut à créer un frein électronique réglable qui permet un asservissement également réglable de la position instantanée du miroir.

Le bobinage secondaire mis en oeuvre dans ce dispositif selon l'invention affecte avantageusement une forme rectangulaire et sa disposition vis-à-vis du bobinage principal est avantageusement telle que le plan de ses spires est perpendiculaire à l'ensemble des plans parallèles définis par les spires du bobinage principal.

Les spires du bobinage secondaire selon l'invention peuvent être en petit nombre, de l'ordre de 1 à 10, deux spires suffisant le plus souvent pour donner des résultats tout à fait satisfaisants.

Ces spires peuvent être soit superposées soit juxtaposées, étant alors enroulées autour du rectangle qui définit leur forme. Dans ce dernier cas elles sont positionnées dans un même plan, ce qui permet un gain en épaisseur avantageux.

Le dispositif selon l'invention peut trouver de nombreuses applications dans tous les secteurs de la technique susceptibles de faire appel à la déviation de rayons électromagnétiques, qu'il s'agisse de leur émission ou de leur réception.

On peut citer, à titre d'exemples non limitatifs :

- en émission : déviation d'un rayon laser à l'aide d'un dispositif double, soit pour la réalisation de dessins ou graphiques sur un support quelconque, soit pour la réalisation de découpes ou de gravures, dans le cas de lasers de forte puissance.

- en réception : balayage d'un plan ou d'un volume pour caméras à Infra-Rouges.

- en émission-réception : reconnaissance de formes au laser ou aux rayons X : copieurs-laser, photocopieurs.

L'invention sera mieux comprise à la lecture de la description qui suit et qui se réfère au dessin annexé, étant bien entendu que cette description ne présente aucun caractère limitatif au regard du dispositif qui fait l'objet de la présente invention.

Dans le dessin annexé :

- la figure 1 représente une coupe transversale en perspective d'un dispositif selon l'invention.

- la figure 2 représente une courbe de réponse d'un dispositif selon l'invention.

- les figures 3a, 3b, 3c représentent en coupe transversale trois variantes du dispositif selon l'invention correspondant à trois configurations différentes du support élastique.

- la figure 4 représente une vue en coupe schématique d'un mode de réalisation d'un dispositif selon l'invention comportant un bobinage secondaire.

- la figure 5 représennte une vue de trois quarts de l'ensemble des deux bobinages représentés à la figure 4.

- la figure 6 représente un schéma synoptique du fonctionnement du dispositif selon l'invention représenté à la figure 4.

En se référant d'abord à la figure 1, on voit l'aimant 1 comportant deux éléments extérieurs 1a et 1c et l'aimant médian 1b.

Le miroir 2 est fixé par collage d'une part au bobinage 3 alimenté en courant par des fils électriques 5 et d'autre part au support élastique 4 lui-même fixé par collage sur l'aimant médian 1b.

Sous l'action d'un courant électrique appliqué au bobinage 3, l'ensemble miroir-bobinage oscille entre deux positions extrêmes dont l'une est représentée en pointillés.

La figure 2 représente une courbe de réponse d'un dispositif selon l'invention dans lequel le support du miroir est réalisé en un matériau élastique à fort coefficient d'amortissement i (t) désigne l'intensité du courant traversant la bobine, $\alpha$ (t) la réponse angulaire du miroir et $\tau$ le temps de montée du système à 63 %.

Ainsi qu'on peut le constater à l'examen de cette courbe, la courbe de réponse du dispositif à un courant rectangulaire est particulièrement satisfaisante, le temps de montée du système à 63 % étant très court.

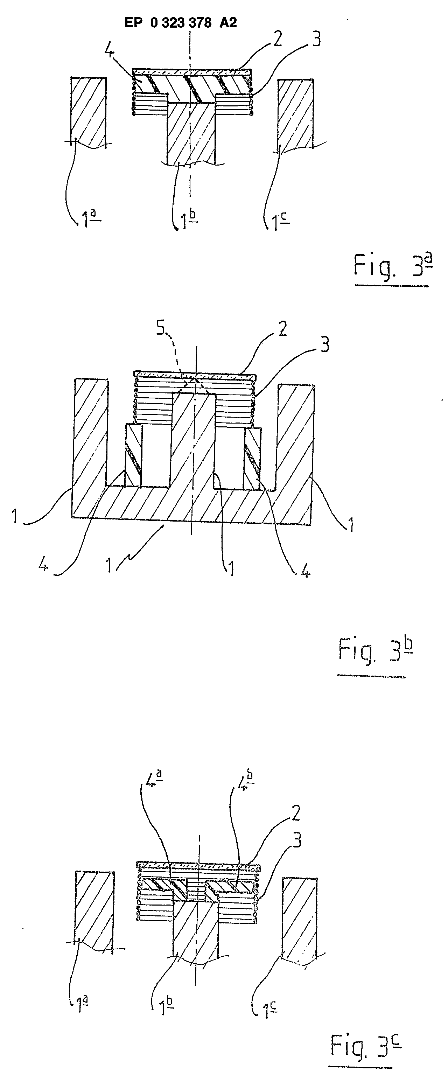

La figure 3a représente un support élastique constitué d'un bloc fixé tout à la fois au miroir 2 et au bobinage 3.

La figure 3b représente un support élastique constitué de deux éléments 4a et 4b dont chacun supporte un côté du bobinage 3, le miroir 2 pouvant reposer sur un couteau 6 représenté en pointillés.

La figure 3c représente un support élastique constitué de deux éléments 4a et 4b donc chacun est fixé à une face interne du bobinage 3.

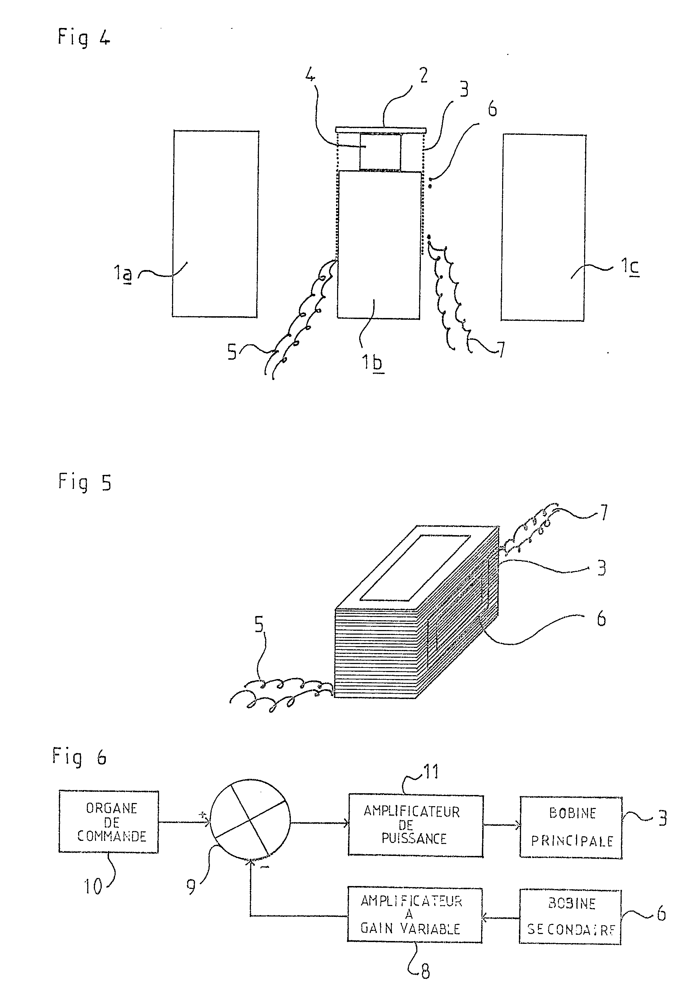

Si on se réfère maintenant à la figure 4, on voit les trois aimants parallèles, à savoir deux aimants externes 1a et 1c et un aimant médian 1b. L'aimant médian 1b est surmonté d'un support élastique 4 qui soutient, en lui étant solidarisé, un miroir 2 solidarisé à un bobinage 3 affectant la forme d'un parallélépipède rectangle et alimenté en courant par des fils électriques 5.

Sur l'une des faces du bobinage 3 située dans l'un des deux entrefers, en l'occurrence celui formé par les aimants 1b et 1c, se trouve solidarisée une bobine secondaire 6 reliée par des fils électriques 7 à un dispositif d'asservissement non représenté.

Si l'on se réfère ensuite à la figure 5, on voit le bobinage principal 3 en forme de parallélépipède rectangle, prolongé par les fils électriques 5, portant sur l'une de ses faces le bobinage secondaire 6 dont la forme est rectangulaire, et dont le plan des spires est rigoureusement perpendiculaire à l'ensemble des plans formés par les spires du bobinage principal 3.

Cette disposition relative des bobinages 3 et 6 a pour conséquence que le courant alimentant le bobinage principal 3 n'induit aucun courant dans le bobinage secondaire 6, le seul courant apparaissant dans ce dernier étant le courant induit par le déplacement de l'ensemble dans le champ magnétique créé par les aimants.

Si l'on se réfère enfin à la figure 6, on voit que le courant induit dans la bobine secondaire 6 est appliqué à un amplificateur à gain variable 8. La tension sortant de cet amplificateur est appliquée à un soustracteur de tension 9 qui reçoit sur une autre entrée la consigne émanant de l'organe de commande 10.

La tension à la sortie du soustracteur 9 est appliquée à un amplificateur de puissance 11 dont la sortie alimente le bobinage principal 3.

On comprend aisément, à l'examen de ce schéma synoptique, comment la bobine secondaire 6 permet de créer un frein électronique autorisant le réglage instantané de l'alimentation en courant du bobinage principal et permettant de ce fait d'éviter les phénomènes de suroscillations ou de suramortissements.

A titre d'exemple, un dispositif selon l'invention conforme à celui représenté sur la figure 1 est constitué de trois plaquettes frittées de Néodyne-Fer de 10 mm de long, 10 mm de haut et 3 mm d'épaisseur, la plaquette médiane étant surbaissée d'1 mm par rapport aux deux plaquettes externes et étant surmontée d'un support de polyuréthane de 10 mm de long, 1 mm de haut et 1 mm d'épaisseur. Sur ce support est fixé, au moyen d'une colle à base de cyanacrylate, un miroir au silicium de 2/10 mm d'épaisseur fixé par collage à une bobine de 4 mm de hauteur constituée de 100 spires de fil de cuivre émaillé de diamètre 4/100 mm, qui coiffe la plaquette médiane.

La tension maximale admissible est de 10 volts, soit un courant de 0,2 A, la résistance d'un tel bobinage étant d'environ 50 ohms. Il en résulte une puissance crête de 2 watts.

Les moyens de pilotage nécessaires pour ce dispositif sont des amplificateurs linéaires pouvant dissiper des puissances de l'ordre de 2 watts.

Un signal électrique triangulaire appliqué à ce dispositif permet d'obtenir un balayage uniforme en temps, la vitesse angulaire du miroir étant uniforme en valeur absolue.

Un tel dispositif peut permettre la digitalisation d'images au moyen d'un rayon dévié par deux miroirs disposés de manière que l'on puisse balayer avec l'un l'axe X d'un plan et avec l'autre l'axe Y du même plan.

Ainsi, si on applique au bobinage du miroir qui permet de balayer l'axe X un signal constitué d'une rampe de 256 marches d'escalier, et au bobinage du miroir qui permet de balayer l'axe Y un signal triangulaire dont la demi-période correspond à une marche du signal précédent, on peut digitaliser une image en 256 demi-périodes. Si $F'$ désigne la fréquence du balayage sur Y, on peut digitaliser une image de 256 x 256 points, en un temps égal à $128/F'$.

Dans le cas où $F' = 3000$ Hz, cette digitalisation peut être réalisée en $128/3000 = 4,2/100$ s, et ce en émission ou en réception.

Un exemple d'illustration d'un dispositif selon l'invention tel que représenté à la figure 4 annexée consiste en un dispositif tel que celui qui vient d'être décrit, auquel est adjoint un bobinage secondaire. A cet effet, on fixe par collage sur l'une des faces de la bobine mise en oeuvre une petite bobine constituée de deux spires parallèles formant un rectangle de 8 mm de long et 2 mm de haut.

Cette petite bobine, reliée à un système électronique de pilotage intégrant un amplificateur à gain variable et un soustracteur de tension lui-même relié, via un amplificateur de puissance, à la bobine principale, confère au dispositif une fiabilité et une reproductibilité exemplaires.

L'adjonction d'un bobinage secondaire permet ainsi de s'affranchir des contraintes liées à la reproduction des supports élastiques, autorisant, ainsi qu'il a déjà été dit, la réalisation de systèmes ne présentant aucun phénomène de suroscillation ou de suramortissement.

Bien entendu, l'invention ne saurait être limitée aux dispositifs décrits, le dispositif selon l'invention pouvant subir un certain nombre de modifications sans pour autant sortir du cadre de la présente invention.

## Revendications

1. Dispositif à miroir(s) oscillant(s) pour la déviation de rayons électromagnétiques, du type comportant au moins un miroir solidaire d'un bobinage alimenté en courant électrique et placé dans un champ magnétique, caractérisé en ce que le champ magnétique est un champ de grande intensité, créé par un ensemble de trois aimants (1a, 1b, 1c) réalisés en un matériau magnétique de produit d'énergie supérieur à 100 kj/m$^3$, disposés parallèlement les uns aux autres, et que, le miroir (2) étant solidarisé au bobinage (3), l'ensemble miroir-bobinage est fixé sur un support élastique (4) lui-même rendu solidaire de l'aimant médian (1b).

2. Dispositif selon la revendication 1, caractérisé en ce que les fixations du miroir (2) sur le bobinage, de l'ensemble miroir (2)-bobinage (3) sur le support élastique (4) et du support élastique (4) sur l'aimant médian (1b) sont réalisés par collage au moyen d'une colle appropriée du type cyanacrylate.

3. Dispositif selon la revendication 1 ou la revendication 2, caractérisé en ce que les trois aimants (1a, 1b, 1c) sont réalisés par frittage du matériau magnétique.

4. Dispositif selon la revendication 3, caractérisé en ce que le matériau magnétique est le néodyne-fer.

5. Dispositif selon la revendication 3 ou la revendication 4, caractérisé en ce que les trois aimants (1a, 1b, 1c) sont constitués de trois plaquettes frittées fixées sur un support et disposées parallèlement l'une par rapport à l'autre, la plaquette médiane (1b) étant légèrement surbaissée par rapport aux plaquettes extérieures (1a, 1c).

6. Dispositif selon la revendication 3 ou la revendication 4, caractérisé en ce que les trois aimants (1a, 1b, 1c) constituent un bloc affectant grossièrement la forme d'un "E", obtenu par frittage et moulage.

7. Dispositif selon l'une quelconque des revendications précédentes, caractérisé en ce que l'ensemble miroir(2)-bobinage(3) coiffe l'aimant médian (1b).

8. Dispositif selon l'une quelconque des revendications précédentes, caractérisé en ce que le support élastique (4) est réalisé en un matériau élastique à fort coefficient d'amortissement.

9. Dispositif selon la revendication 8, caractérisé en ce que le matériau élastique est un polyuréthane.

10. Dispositif selon l'une quelconque des revendications 1 à 7, caractérisé en ce que le support élastique (4) est réalisé en un matériau élastique à faible coefficient d'amortissement.

11. Dispositif selon la revendication 10, caractérisé en ce que le dispositif est associé à une commande électronique intégrant un filtre destiné à compenser la résonance propre du système.

12. Dispositif selon l'une quelconque des revendications précédentes, caractérisé en ce que le support élastique (4) affecte la forme d'un parallélépipède rectangle et est fixé au miroir seul.

13. Dispositif selon l'une quelconque des revendications précédentes, caractérisé en ce que le support élastique (4) constitue un bloc fixé à la fois au miroir et aux faces internes du bobinage.

14. Dispositif selon l'une quelconque des revendications précédentes, caractérisé par l'adjonction, au bobinage (3) solidaire du miroir, d'un bobinage secondaire (6) de moindres dimensions, solidarisé à l'une des deux faces du bobinage principal (3) qui se trouvent dans les entrefers formés par les trois aimants parallèles (1a), (1b), (1c) et positionné de telle manière qu'il ne puisse recueillir aucun courant induit dans le bobinage principal (3), le courant induit dans le bobinage secondaire (6) par les oscillations du miroir (2) étant traité par un mode d'asservissement approprié permettant un réglage de la position de la vitesse et de l'accélération instantanées du miroir (2) satisfaisant aux exigences de linéarité du système.

15. Dispositif selon la revendication 14, caractérisé en ce que le bobinage secondaire (6) est constitué d'un petit nombre de spires superposées ou juxtaposées et présente une forme rectangulaire, étant positionné sur le bobinage principal (3) de telle manière que le plan de ses spires soit perpendiculaire à l'ensemble des plans parallèles formés par les spires dudit bobinage principal (3).

16. Dispositif selon la revendication 14 ou la revendication 15, caractérisé en ce que le mode d'asservissement mis en oeuvre pour le traitement du courant induit dans le bobinage secondaire (6) est choisi dans le groupe formé par les modes d'asservissement analogiques et les modes d'asservissement numériques.

17. Dispositif selon la revendication 16, caractérisé en ce que le mode d'asservissement mis en oeuvre est un mode d'asservissement analogique choisi dans le groupe que constituent les modes d'asservissement proportionnels, les modes d'asservissement dérivés, les modes d'asservissement intégraux, les modes d'asservissement proportionnels dérivés, les modes d'asservissement proportionnels intégraux, les modes d'asservissement intégraux dérivés et les modes d'asservissement proportionnels intégraux dérivés.

18. Dispositif selon la revendication 17, caractérisé en ce que le mode d'asservissement mis en oeuvre est un mode d'asservissement proportionnel dérivé consistant en un amplificateur à gain variable (8) suivi d'un soustracteur de tension (9) qui reçoit sur son autre entrée la consigne émanant d'un organe de commande (10), la tension à la sortie du soustracteur (9) étant appliquée à un amplificateur de puissance (11) dont la sortie alimente le bobinage principal (3).

Fig. 1

Fig.2

Fig. 3ª

Fig. 3ᵇ

Fig. 3ᶜ

Fig 4

Fig 5

Fig 6

| ORGANE DE COMMANDE | AMPLIFICATEUR DE PUISSANCE | BOBINE PRINCIPALE |
| AMPLIFICATEUR A GAIN VARIABLE | BOBINE SECONDAIRE | |